# EUROPÄISCHE PATENTSCHRIFT

(11) **EP 3 017 081 B1**
(45) Veröffentlichungstag und Bekanntmachung des Hinweises auf die Patenterteilung: **08.01.2020**
(21) Anmeldenummer: 14736626.4
(22) Anmeldetag: 30.06.2014
(51) Int. Cl.: C23C 14/34

(54) **TARGETPRÄPARATION**
TARGET PREPARATION
PRÉPARATION DE CIBLE

(30) Priorität: 03.07.2013 DE 102013011072
(43) Veröffentlichungstag der Anmeldung: 11.05.2016
(73) Patentinhaber: Oerlikon Surface Solutions AG, Pfäffikon, 8808 Pfäffikon (CH)
(72) Erfinder: KURAPOV, Denis, 8880 Walenstadt (CH); KRASSNITZER, Siegfried, 6800 Feldkirch (AT)
(74) Vertreter: Misselhorn, Hein-Martin
(86) Internationale Anmeldenummer: PCT/EP2014/001783
(87) Internationale Veröffentlichungsnummer: WO 2015/000578

(56) Entgegenhaltungen:
- EP-A1- 2 521 159
- JP-A- 2002 129 326
- US-A1- 2008 190 758
- US-A1- 2011 220 490
- DATABASE WPI Week 198942 Thomson Scientific, London, GB; AN 1989-305097 XP002729507, & JP H01 225772 A (NIPPON TELEGRAPH & TELEPHONE CORP) 8. September 1989 (1989-09-08)
- KELLY P J ET AL: "The deposition of aluminium oxide coatings by reactive unbalanced magnetron sputtering", SURFACE AND COATINGS TECHNOLOGY, ELSEVIER, AMSTERDAM, NL, Bd. 86-87, 1. Dezember 1996 (1996-12-01), Seiten 28-32, XP026499000, ISSN: 0257-8972, DOI: 10.1016/S0257-8972(96)02997-0 [gefunden am 1996-12-01]

## Beschreibung

Die vorliegende Erfindung bezieht sich auf ein Verfahren zum Beschichten von Substraten.

Die Erfindung bezieht sich insbesondere auf ein Verfahren zur Vorbereitung einer Abscheidung aus der Gasphase unter Vakuum, bei dem ein Target als Materialquelle verwendet wird, von dessen Oberfläche Partikel zum Substrat fliegen und sich auf diesem ablagern. Häufig kommt dabei noch ein Reaktivgas zum Einsatz, dessen Atome und/oder Moleküle mit den Partikeln reagieren, so dass sich die entsprechende chemische Verbindung auf dem Substrat ablagert. In diesem Fall liegt ein reaktiver Beschichtungsprozess vor.

Es sind einige solcher Beschichtungsprozesse bekannt. Beispielhaft sind hier lediglich das Magnetronsputtern und das Funkenverdampfen genannt. Die entsprechenden Targetoberflächen sind unterschiedlichen Umwelteinflüssen ausgesetzt. Beispielsweise muss zum Be- und Entladen der Beschichtungskammer in vielen Fällen eine Kammertüre geöffnet werden, so dass die Targetoberfläche der normalen Raumatomsphäre ausgesetzt ist. Manchmal, wenn eine Targetvergiftung aufgrund des Reaktivgases vorliegt, muss die Targetoberfläche auch speziellen mechanischen Behandlungen ausgesetzt werden, wie zum Beispiel Sandstrahlen. Dies alles sind Umstände, die dazu führen, dass die Targetoberfläche sich aufgrund unterschiedlicher Umwelteinflüsse von Beschichtungslauf zu Beschichtungslauf unterscheidet. Würde mit einer solchen Targetoberfläche sofort angefangen zu beschichten, so ergäben sich nicht reproduzierbare Ergebnisse. Da vor allem der Anfang der Beschichtung nicht reproduzierbar ist, hat dies unter anderem wesentlichen Einfluss auf die Schichthaftung. Vor allem im Bereich des Verschleissschutzes sind jedoch solch unkalkulierbare Unterschiede in der Haftung und der sonstigen Schichteigenschaften nicht tolerierbar.

Dokument JP 2002 129326 A offenbart ein Sputterverfahren mit simultaner Substratreinigung.

Um dem entgegen zu wirken, wird nach Schliessen und Evakuation der Beschichtungskammer zunächst die Beschichtung dergestalt gestartet, dass mittels einer Abdeckung für eine gewisse Zeit verhindert wird, dass das Beschichtungsmaterial auf dem Substrat niederschlägt und ablegt. Einen solchen Vorgang nennt man Targetkonditionierung.

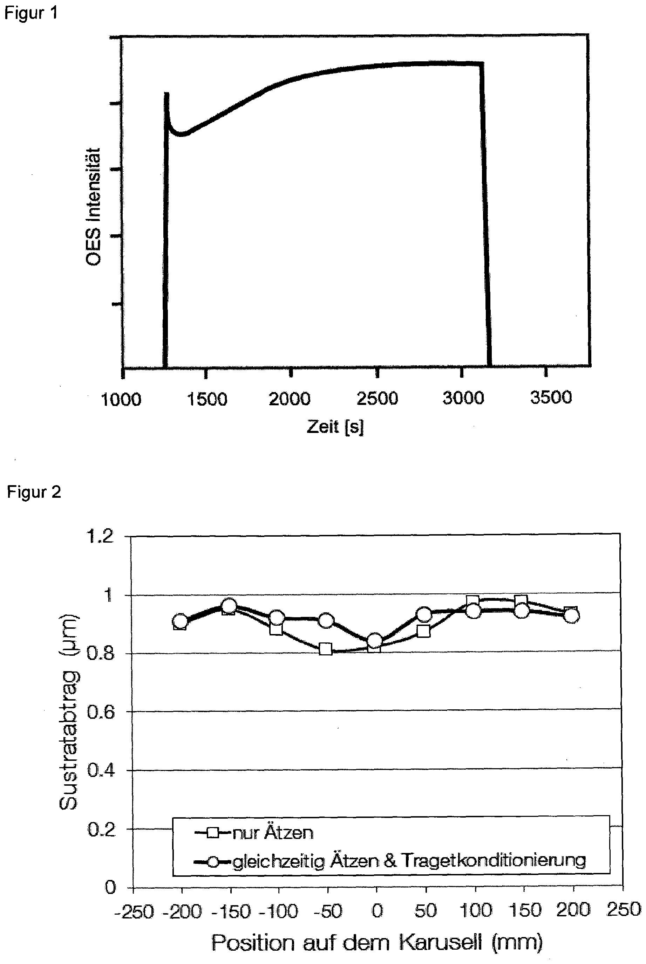

Dabei kann die Targetkonditionierung mitunter eine halbe Stunde und länger in Anspruch nehmen. Figur 1 zeigt während dieser Konditionierung das optische Signal eines Plasmas, das vor einem Chrom enthaltenden Target brennt. Deutlich erkennbar ist, dass sich erst nach ca. 30 min das OES Signal stabilisiert, was ein Zeichen dafür ist, dass die Konditionierung fertig ist und sich nichts Wesentliches mehr an der Targetoberfläche ändert. Entsprechend führt die dafür benötigte Zeit zu einer Verlängerung der Beschichtungszeit, gerechnet vom Beladen der Beschichtungsanlage bis zum Entladen nach dem Beschichten.

Dass für viele Anwendungen eine gute Schichthaftung notwendig ist, wurde bereits angesprochen. Um eine gute Schichthaftung zu erreichen, muss beispielsweise das Substrat eine saubere Oberfläche besitzen. Die Reinigung des zu beschichtenden Substrates wird dabei grundsätzlich ausserhalb der Beschichtungskammer vorgenommen. Allerdings werden einige vorbereitende Behandlungsschritte der Substratoberfläche erst bei geschlossener Beschichtungskammer in der Kammer und unter Vakuum durchgeführt. Es ist besonders vorteilhaft, die Substratoberfläche kurz vor der Beschichtung einem Ätzverfahren und besonders bevorzugt mittels Plasma, d.h. einem Plasmaätzverfahren auszusetzen. Dabei ist es durchaus üblich, bis knapp 1 µm von der Oberfläche zu entfernen. Auf diese Weise werden letzte Schmutzpartikel entfernt und es kommt bezüglich bestimmter Substratmaterialien zu einer oberflächennahen Konzentrationsverarmung, wodurch die Haftung des Schichtmaterials, welches im anschliessenden Beschichtungsschritt aufgebracht wird, stark erhöht wird. In manchen Fällen wird durch die Vorbehandlung und insbesondere durch das Plasmaätzen die Oberfläche des Substrates aktiviert, was wiederum zu einer besseren Haftung beiträgt. Nachteilig hierbei ist allerdings, dass auch dieser Verfahrensschritt erheblich Zeit in Anspruch nimmt, so dass, nachdem die Beschichtungskammer geschlossen wurde und mit der Evakuation begonnen wurde, manchmal durchaus eine Stunde einkalkuliert werden muss, bevor mit dem eigentlichen Beschichten begonnen werden kann. Die langen Wartezeiten schlagen direkt auf die Gesamtdauer des Verfahrens und damit auf die Herstellungskosten solcher Schichten durch.

Es wäre daher wünschenswert, ein Verfahren zur Verfügung zu haben, das deutlich weniger Zeit in Anspruch, nimmt ohne dass sich die Produktqualität und insbesondere die Haftung der Schicht auf dem Substrat verschlechtert.

Diesem Wunsch liegt die Aufgabe der vorliegenden Erfindung zugrunde.

Bei ihren Entwicklungsarbeiten haben die Erfinder zu ihrer Überraschung festgestellt, dass sich einige der Verfahrensschritte, was die Konditionierung des Targets und die Vorbehandlung der Substrate in der Beschichtungskammer betrifft, parallelisieren lassen. Genauer gesagt konnten die Erfinder, nachdem die Beschichtungskammer auf das benötigte Mass evakuiert war, die Targetkonditionierung starten und gleichzeitig mit der Vorbehandlung der Substrate beginnen. Obwohl beide Prozesse in der Regel ein in der Kammer brennendes Plasma benötigen, beeinflussen sich diese beiden Prozesse nicht negativ. Noch viel erstaunlicher war, dass dies nicht lediglich für eine Substratposition zutrifft sondern über die gesamte Höhe, über die in der Beschichtungskammer Substrate in der Regel auf einem Karussell angeordnet sind, seine Gültigkeit hat. Dementsprechend zeigt Figur 2 die Dicke der im Rahmen der Substratvorbehandlung entfernten Schicht in Abhängigkeit von der Substratposition und zwar einmal ohne dass gleichzeitig die Targets konditioniert wurden und einmal bei gleichzeitiger Targetkonditionierung. Gemessen wurde Substratabtrag und Karussell. Wie der Figur 2 zu entnehmen ist, wird die Effizienz und Homogenität des Plasmaätzens nur in sehr geringem Masse davon beeinflusst, ob gleichzeitig die Targets konditioniert werden oder nicht.

Damit kann das erfindungsgemässe Verfahren zur Beschichtung von Werkstücken gemäß Anspruch 1 folgende Schritte umfassen:
- Beladen einer Beschichtungskammer mit den zu beschichtenden Werkstücken,
- Schliessen und Evakuieren der Beschichtungskammer auf einen vorbestimmten Prozessdruck,
- Starten einer Beschichtungsquelle, welche als Materialquelle ein Traget umfasst und wodurch Teilchen aus der Oberfläche des Targets in Richtung Substrate beschleunigt werden,
dadurch gekennzeichnet, dass zwischen Targetoberfläche und Substrat so lange eine Abschirmung vorgesehen ist, bis das Target konditioniert ist, wobei währenddessen zumindest teilweise die zu beschichtenden Substrate einer Vorbehandlung unterzogen werden, wobei die Vorbehandlung einen Verfahrensschritt umfasst, im Zuge dessen die Werkstücke nitriert werden.

Die Vorbehandlung der Substrate kann ein Ätzverfahren umfassen.
Gemäss der Erfindung kann die Vorbehandlung als einen Verfahrensschritt das Nitrieren der Substratoberfläche umfassen. Beispielsweise kann hierzu ein Gasgemisch aus Stickstoff, Argon, Wasserstoff in die Kammer eingelassen werden.

Die Konditionierung des Targets kann zum Beispiel dann beendet werden, wenn das von den Teilchen ausgesandte optische Signal sich im Wesentlichen nicht mehr ändert. Das optische Signal kann mittels einer OES Messung gemessen werden.

Besonders geeignet ist das Verfahren für Beschichtungsquellen, die Magnetronsputterquellen sind.

Die Beschichtungskammer kann mehrere Magnetronsputterquellen umfassen, welche sequenziell periodisch in überlappenden Zeitintervallen an einen DC Leistungsgenerator mit hoher Leistungsabgabe angeschlossen werden, so dass es auf den Targetoberflächen zeitweise periodisch zu Stromdichten von mehr als 0.2A/cm² kommt.

Beim erfindungsgemässen Verfahren kann als Beschichtungsquelle aber auch eine Lichtbogenverdampfungsquelle eingesetzt werden.

## Patentansprüche

1. Verfahren zur Beschichtung von Werkstücken mit folgenden Schritten:
- Beladen einer Beschichtungskammer mit den zu beschichtenden Werkstücken,
- Schliessen und Evakuieren der Beschichtungskammer auf einen vorbestimmten Prozessdruck,
- Starten einer Beschichtungsquelle, welche als Materialquelle ein Traget umfasst und wodurch Teilchen aus der Oberfläche des Targets in Richtung Substrate beschleunigt werden,
**dadurch gekennzeichnet, dass** zwischen Targetoberfläche und Substrat so lange eine Abschirmung vorgesehen ist, bis das Target konditioniert ist, wobei währenddessen zumindest teilweise die zu beschichtenden Substrate einer Vorbehandlung unterzogen werden, wobei die Vorbehandlung einen Verfahrensschritt umfasst, im Zuge dessen die Werkstücke nitriert werden.

2. Verfahren nach Anspruch 1, **dadurch gekennzeichnet, dass** die Vorbehandlung der Substrate ein Ätzverfahren umfasst.

3. Verfahren nach einem der Ansprüche 1 bis 2, **dadurch gekennzeichnet, dass** die Konditionierung des Targets dann beendet wird, wenn das von den Teilchen ausgesandte optische Signal sich nicht mehr ändert.

4. Verfahren nach Anspruch 3, **dadurch gekennzeichnet, dass** das optische Signal mittels einer OES Messung gemessen wird.

5. Verfahren nach einem der vorangehenden Ansprüche, **dadurch gekennzeichnet, dass** die Beschichtungsquelle eine Magnetronsputterquelle ist.

6. Verfahren nach Anspruch 5, **dadurch gekennzeichnet, dass** die Beschichtungskammer mehrere Beschichtungsquellen umfasst, welche sequenziell periodisch in überlappenden Zeitintervallen an einen DC Leistungsgenerator mit Leistungsabgabe angeschlossen werden, so dass es auf den Targetoberflächen zeitweise periodisch zu Stromdichten von mehr als 0.2A/cm² kommt.

7. Verfahren nach einem der Ansprüche 1 bis 4, **dadurch gekennzeichnet, dass** die Beschichtungsquelle eine Lichtbogenverdampfungsquelle ist.

8. Verfahren nach einem der vorangehenden Ansprüche, **dadurch gekennzeichnet, dass** zum Nitrieren ein Gasgemisch in die Kammer eingelassen wird, welches die Elemente Stickstoff, Argon und Wasserstoff enthält.

## Claims

1. A method for coating workpieces, comprising the following steps:
- loading a coating chamber with the workpieces to be coated,
- closing and evacuating the coating chamber to a predetermined process pressure,
- starting a coating source, which comprises a target as a material source, and whereby particles are accelerated from the surface of the target in the direction toward substrates,
**characterized in that** a shield is provided between the target surface and the substrate until the target has been conditioned, wherein the substrates to be coated are, at least in part, simultaneously subjected to a pre-treatment, wherein the pre-treatment includes a method step during which the workpieces are nitrided.

2. The method according to, claim 1, **characterized in that** the pre-treatment of the substrates comprises an etching process.

3. The method according to any one of the claims 1 to 2, **characterized in that** the conditioning of the target is ended when the optical signal emitted by the particles no longer changes.

4. The method according to claim 3, **characterized in that** the optical signal is measured by means of an OES measurement.

5. The method according to any one of the preceding claims, **characterized in that** the coating source is a magnetron sputtering source.

6. The method according to claim 5, **characterized in that** the coating chamber comprises several coating sources which, in a sequentially periodical manner, are connected in overlapping time intervals to a DC power generator having a power output, so that current densities of more than 0.2 A/cm² periodically occur on the target surfaces from time to time.

7. The method according to any one of the claims 1 to 4, **characterized in that** the coating source is an arc evaporation source.

8. The method according to any one of the preceding claims, **characterized in that** a gas mixture, which includes the elements nitrogen, argon and hydrogen, is introduced into the chamber for nitriding.

## Revendications

1. Procédé de revêtement de pièces, comprenant les étapes suivantes consistant à :
- charger une chambre de revêtement avec les pièces à revêtir,
- fermer et évacuer la chambre de revêtement à une pression de traitement prédéterminée,
- démarrer une source de revêtement qui comprend une cible en tant que source de matériau, moyennant quoi des particules sont accélérées depuis la surface de la cible en direction des substrats,
**caractérisé en ce que**
un blindage est prévu entre la surface cible et le substrat jusqu'à ce que la cible soit conditionnée, et ce faisant les substrats à revêtir sont soumis au moins partiellement à un prétraitement, le prétraitement comprenant une étape de procédé au cours de laquelle les pièces sont nitrurées.

2. Procédé selon la revendication 1,
**caractérisé en ce que**
le prétraitement des substrats comprend un processus d'attaque chimique.

3. Procédé selon l'une des revendications 1 à 2,
**caractérisé en ce que**
le conditionnement de la cible est terminé lorsque le signal optique émis par les particules ne change plus.

4. Procédé selon la revendication 3,
**caractérisé en ce que**
le signal optique est mesuré par une mesure dite OES.

5. Procédé selon l'une des revendications précédentes,
**caractérisé en ce que**
la source de revêtement est une source de pulvérisation par magnétron.

6. Procédé selon la revendication 5,
**caractérisé en ce que**
la chambre de revêtement comprend plusieurs sources de revêtement qui sont connectées séquentiellement et périodiquement, à intervalles de temps se chevauchant, à un générateur de puissance de courant continu avec une sortie de puissance telle que des densités de courant supérieures à 0,2 A/cm² sont générées périodiquement temporairement sur les surfaces cibles.

7. Procédé selon l'une des revendications 1 à 4,
**caractérisé en ce que**
la source de revêtement est une source d'évaporation à l'arc.

8. Procédé selon l'une des revendications précédentes,
**caractérisé en ce que**
pour la nitruration, un mélange gazeux contenant les éléments azote, argon et hydrogène est introduit dans la chambre.
